# EUROPEAN PATENT APPLICATION

(11) **EP 4 658 031 A1**
(43) Date of publication of application: **03.12.2025**
(21) Application number: 25733596.8
(22) Date of filing: 16.01.2025
(51) Int. Cl.: H10F 77/30

(54) **SOLAR CELL AND PREPARATION METHOD THEREFOR, AND PHOTOVOLTAIC MODULE**

(30) Priority: 19.04.2024 CN 202410485399; 08.05.2024 CN 202410563104; 27.08.2024 CN 202411184801; 27.08.2024 CN 202422086173 U; 26.09.2024 CN 202411352531
(71) Applicant: CSI Cells (YangZhou) Co., Ltd., Yangzhou, Jiangsu 225000 (CN); CSI Cells Co., Ltd., Suzhou, Jiangsu 215000 (CN)
(72) Inventor: YE, Xiaoya, Yangzhou, Jiangsu 225001 (CN); CHEN, Haiyan, Yangzhou, Jiangsu 225001 (CN); DENG, Weiwei, Yangzhou, Jiangsu 225001 (CN)
(74) Representative: karo IP
(86) International application number: PCT/CN2025/072690
(87) International publication number: WO 2025/218294

(57) **Abstract**

A solar cell and a preparation method thereof, and a photovoltaic module are disclosed. The solar cell includes a silicon substrate, the silicon substrate includes a first surface and a second surface that are disposed opposite to each other, the second surface includes a first region and a second region. A first tunneling and passivation contact structure is provided on the first region, a second passivation structure is provided on the first region and the second region. The second passivation structure on the first region is disposed on the first tunneling and passivation contact structure. A height difference H₁ between a portion of a surface of the second passivation structure at a side facing away from the silicon substrate on the first region and another portion of the surface of the second passivation structure at the side facing away from the silicon substrate on the second region is 0.01µm to 8µm, and/or a height difference H₂ between a portion of a surface of the second passivation structure at a side facing towards the silicon substrate on the first region and another portion of the surface of the second passivation structure at the side facing towards the silicon substrate on the second region is 0.01µm to 8µm.

## Description

### CROSS-REFERENCE TO RELATED APPLICATIONS

The present application claims priorities to Chinese patent application No. 202411184801.8 entitled "SOLAR CELL AND PREPARATION METHOD THEREOF" and filed with the China National Intellectual Property Administration on August 27, 2024, Chinese patent application No. 202422086173.1 entitled "PHOTOVOLTAIC CELL AND PHOTOVOLTAIC MODULE" and filed with the China National Intellectual Property Administration on August 27, 2024, Chinese patent application No. 202411352531.7 entitled "SOLAR CELL AND PREPARATION METHOD THEREOF" and filed with the China National Intellectual Property Administration on September 26, 2024, Chinese patent application No. 202410563104.7 entitled "SOLAR CELL AND PREPARATION METHOD THEREOF" and filed with the China National Intellectual Property Administration on May 8, 2024, and Chinese patent application No. 202410485399.0 entitled "SOLAR CELL AND PREPARATION METHOD THEREOF" and filed with the China National Intellectual Property Administration on April 19, 2024, which are hereby incorporated by reference in their entireties.

### TECHNICAL FIELD

The present disclosure relates to the technical field of solar cells, and more particularly, to a solar cell and a preparation method thereof, and a photovoltaic module.

### BACKGROUND

With the rapid development of the photovoltaic industry, performance and efficiency requirements for solar cells in both domestic and international markets continue to rise. Industry manufacturers are focusing on research and development of high-efficiency cells. TOPCon (Tunnel Oxide Passivated Contact) cells can improve surface passivation performance of the cells and reduce a metal contact recombination current by sequentially preparing an ultra-thin tunneling oxide and a doped polysilicon layer on a back surface of a silicon substrate, which effectively improves an open-circuit voltage and a short-circuit current of the cells. In recent years, the market share of the TOPCon cells has grown rapidly, and has gradually surpassed PERC cells to become the mainstream technology of the solar cells.

The back surface of the TOPCon cell is formed with a tunneling and passivation contact structure formed by a tunneling oxide layer and a doping polysilicon layer, thereby the efficiency of the cell is significantly improved. A larger thickness of the doped polysilicon on the back surface causes a larger burn-through window of a metal-resistant slurry, but also causes a higher parasitic absorption. Therefore, one of the efficiency improvement schemes for the TOPCon cell is to dispose Poly finger structure on the back surface to reduce or completely remove the thickness of the doped polysilicon in a non-metal region, and reduce parasitic absorption of long wave band on the back surface. Therefore, it is necessary to control the thickness of the polysilicon in both metal and non-metal regions.

If the doped polysilicon on the metal region of the back surface is too thin, the slurry penetrates the doped polysilicon during sintering, and thus will destroy the bottom tunneling oxide layer, resulting in a poor passivation effect and a low cell efficiency. If the doped polysilicon on the non-metal region of the back surface is too thick, the parasitic absorption is high and the cell efficiency is low. If the doped polysilicon on the non-metal region is too thin, the field passivation effect is poor and the cell efficiency is low. Presently, the thickness of the doped polysilicon layer on the back surface of the mass-produced TOPCon cells is generally between 100nm to 150nm, which is mainly limited by the sintering window of the slurry and thus cannot be thinner any more.

Therefore, with respect to the above technical problems, it is necessary to provide a solar cell and a preparation method thereof.

### SUMMARY

A purpose of the present disclosure is to provide a solar cell and a preparation method thereof to balance the passivation effect and the reduction of parasitic absorption, and significantly improve the cell efficiency and double-side ratio while improving the technology window.

In order to realize the above purpose, an embodiment of the present disclosure provides the following technical solutions.

A solar cell includes a silicon substrate. The silicon substrate includes a first surface and a second surface that are disposed opposite to each other. The second surface includes a first region and a second region. A first tunneling and passivation contact structure is provided on the first region, a second passivation structure is provided on the first region and the second region, the second passivation structure on the first region is disposed on the first tunneling and passivation contact structure. A height difference H₁ between a portion of a surface of the second passivation structure at a side facing away from the silicon substrate on the first region and another portion of the surface of the second passivation structure at the side facing away from the silicon substrate on the second region is 0.01µm to 8µm, and/or a height difference H₂ between a portion of a surface of the second passivation structure at a side facing towards the silicon substrate on the first region and another portion of the surface of the second passivation structure at the side facing towards the silicon substrate on the second region is 0.01µm to 8µm.

In an embodiment, the second passivation structure on the second region directly contacts with the second surface of the silicon substrate. The first tunneling and passivation contact structure on the first region includes a tunneling layer and a second doped layer stacked in sequence. The solar cell further includes a second electrode that is disposed on the first region and that directly contacts with the second doped layer.

In an embodiment, the height difference H₁ between the protion of the surface of the second passivation structure at the side facing away from the silicon substrate on the first region and the another portion of the surface of the second passivation structure at the side facing away from the silicon substrate on the second region is 0.05µm to 8µm or 3µm to 6µm; and/or the height difference H₂ between the portion of the surface of the second passivation structure at the side facing towards the silicon substrate on the first region and the another portion of the surface of the second passivation structure at the side facing towards the silicon substrate on the second region is 0.05µm to 8µm or 3µm to 6µm.

In an embodiment, the tunneling layer is any one of a silicon oxide layer and a silicon nitride oxide layer, or any combination thereof; and/or, the tunneling layer has a thickness of 0.5nm to 3nm or 1.5nm to 2.5nm; and/or the second doped layer is a doped polysilicon layer with a thickness of 1nm to 150nm or 50nm to 100nm; and/or the second doped layer has a same doping type as that of the silicon substrate, and the second doped layer has a surface doping concentration of 2E20cm⁻³ to 3E21cm⁻³ or 5E20cm⁻³ to 2E21cm⁻³.

In an embodiment, the silicon substrate is sunken on the second region.

In an embodiment, the first region and the second region in the second surface of the silicon substrate has a polished surface obtained by polishing a texture with a pyramid structure, and a size of a pyramid base of the pyramid structure on the first region is smaller than that on the second region.

In an embodiment, the size of the pyramid base in the first region is 3µm to 20µm, and the size of the pyramid base in the second region is 3µm to 50µm; or the size of the pyramid base on the first region is 8µm to 15µm and the size of the pyramid base on the second region is 15µm to 30µm.

In an embodiment, a second tunneling and passivation contact structure is provided on the second region, the second passivation structure on the second region is disposed on the second tunneling and passivation contact structure, and the second tunneling and passivation contact structure has a thickness less than a thickness of the first tunneling and passivation contact structure.

In an embodiment, a tunneling layer, a second doped layer, a barrier layer and a third doped layer are provided on the first region, and a tunneling layer and a second doped layer are provided on the second region, the solar cell further includes a second electrode that is disposed on the first region and that directly contacts with the third doped layer.

In an embodiment, a tunneling layer, one second doped layer, one barrier layer, and a third doped layer are provided on the first region, and a tunneling layer and one second doped layer are provided on the second region; or a tunneling layer, one second doped layer, one barrier layer and a third doped layer are provided on the first region, a tunneling layer, one second doped layer, one barrier layer and a third doped layer are provided on the second region, and the third doped layer on the second region has a thickness that is less than that of the third doped layer on the first region; or a tunneling layer, at least two second doped layers and at least two barrier layers that are alternately stacked, and a third doped layer are provided on the first region, and a tunneling layer, at least two second doped layers and at least one barrier layer that are alternately stacked are provided on the second region; or a tunneling layer, at least two second doped layers and at least two barrier layers that are alternately stacked and a third doped layer are provided on the first region, a tunneling layer, at least two second doped layers and at least two barrier layers that are alternately stacked and a third doped layer are provided on the second region, the third doped layer on the second region has a thickness that is less than that of the third doped layer on the first region.

In an embodiment, the first tunneling and passivation contact structure includes a tunneling layer and at least one doped layer that are disposed on the first region, the second tunneling and passivation contact structure includes a tunneling layer and at least one layer doped layer that are disposed on the first region, and a total thickness of the at least one doped layer on the first region is greater than a total thickness of the at least one doped layer on the second region.

In an embodiment, the height difference H₁ between the portion of the surface of the second passivation structure at the side facing away from the silicon substrate on the first region and the another portion of the surface of the second passivation structure at the side facing away from the silicon substrate on the second region is 0.01µm to 0.153µm or 0.048µm to 0.102µm; and/or the height difference H₂ between the portion of the surface of the second passivation structure at the side facing towards the silicon substrate on the first region and the another portion of the surface of the second passivation structure at the side facing towards the silicon substrate on the second region is 0.01µm to 0.153µm or 0.048µm to 0.102µm.

In an embodiment, the tunneling layer is any one of a silicon oxide layer and a silicon nitride oxide layer, or any combination thereof; and/or the tunneling layer has a thickness of 0.5nm to 3nm or 1.5nm to 2.5nm; and/or the barrier layer is any one of a silicon oxide layer and a silicon carbide layer, or any combination thereof; and/or the barrier layer has a thickness of 0.5nm to 3nm or 1.5nm to 2nm; and/or, the second doped layer has a same doping type as that of the silicon substrate, and the second doped layer has a surface doping concentration of 1E20cm⁻³ to 9E20cm⁻³ or 3E20cm⁻³ to 5E20cm⁻³ and/or the third doped layer has a same doping type as that of the silicon substrate, and the third doped layer has a surface doping concentration of 2E20cm⁻³ to 3E21cm⁻³ or 5E20cm⁻³ to 2E21cm⁻³; and/or the second doped layer is a doped polysilicon layer with a thickness of 1nm to 100nm or 1nm to 50nm; and/or the third doped layer is a doped polysilicon layer with a thickness of 1nm to 150nm or 50nm to 100nm; and/or a total thickness of the second doped layer and the third doped layer on the first region is 50nm to 150nm or 60nm to 100nm.

In an embodiment, the first region includes a plurality of first sub-regions that are distributed in parallel and equidistantly spaced apart, and the second region includes a plurality of second sub-regions that are distributed in parallel and equidistantly spaced apart, the first sub-region and the second sub-region are alternately distributed, and the first sub-region has a width of 20µm to 600µm and the second sub-region has a width of 100µm to 800µm.

In an embodiment, the second passivation structure includes one of a silicon oxide layer, an alumina layer, a silicon nitride layer and a silicon nitride oxide layer, or any combination of two or more thereof.

In an embodiment, the second passivation structure includes a silicon oxide layer, an alumina layer and a silicon nitride layer stacked in sequence, the silicon oxide layer has a thickness of 0.1nm to 3nm, the alumina layer has a thickness of 3nm to 10nm or 4nm to 8nm, and the silicon nitride layer has a thickness of 60nm to 100nm or 70nm to 90nm. Alternatively, the second passivation structure includes a silicon oxide layer and a silicon nitride layer stacked in sequence, the silicon oxide layer has a thickness of 1nm to 30nm, and the silicon nitride layer has a thickness of 60nm to 100nm or 70nm to 90nm.

In an embodiment, the first doped layer has an opposite doping type to that of the silicon substrate, and the first doped layer has a surface doping concentration of 1E18cm⁻³ to 5E19cm⁻³, and has a thickness of 10nm to 100nm; and/or a first passivation structure is disposed on the first doped layer, the first passivation structure includes an alumina layer and a silicon nitride layer stacked in sequence, the alumina layer has a thickness of 3nm to 10nm or 4nm to 8nm, and the silicon nitride layer has a thickness of 60nm to 100nm or 70nm to 90nm.

In an embodiment, a photovoltaic module includes the above solar cell.

Another embodiment of the present disclosure provides the following technical solutions.

In an embodiment, a method for preparing a solar cell includes the steps of: providing a silicon substrate, the silicon substrate including a first surface and a second surface that are disposed opposite to each other, the second surface including a first region and a second region; preparing a tunneling and passivation contact structure on the first region of the second surface; preparing a second passivation structure on the first region and the second region of the second surface. A height difference H₁ between a portion of a surface of the second passivation structure at a side facing away from the silicon substrate on the first region and another portion of the surface of the second passivation structure at the side facing away from the silicon substrate on the second region is 0.01µm to 8µm, and/or a height difference H₂ between a portion of a surface of the second passivation structure at a side facing towards the silicon substrate on the first region and another portion of the surface of the second passivation structure at the side facing towards the silicon substrate on the second region is 0.01µm to 8µm.

In an embodiment, after the preparing the tunneling passivation contact structure on the first region of the second surface and before the preparing the second passivation structure on the first region and the second region of the second surface, the method further includes: preparing a mask layer on the second surface; performing graphical mask opening on the mask layer on the second region using laser technology; removing all or a portion of the tunneling and passivation contact structure on the second region using a wet etching process to retain the tunneling and passivation contact structure on the first region; and removing the mask layer on the first region to expose the tunneling and passivation contact structure on the first region.

In an embodiment, the method further includes preparing a texture with a pyramid structure on the first surface and the second surface of the silicon substrate through an alkali texturing process, the pyramid having a size of 0.5µm to 3µm; and polishing the second surface of the silicon substrate uses an aqueous alkali before preparing the tunneling and passivation contact structure, so as to form a plurality of pyramid bases on the second surface, the pyramid base having a size of 3µm to 20µm or 8µm to 15µm.

In an embodiment, the tunneling and passivation contact structure includes one tunneling layer, one second doped layer, one barrier layer, and a third doped layer stacked in sequence. The wet etching process includes: all or a portion of the third doped layer are removed on the second region using alkali etching technology; or removing all of the third doped layer and the barrier layer and at least a part of the second doped layer on the second region by using alkali etching technology.

In an embodiment, the tunneling and passivation contact structure includes one tunneling layer, at least two second doped layers and at least two barrier layers that are alternately stacked, and a third doped layer. The wet etching process includes: removing all or a portion of the third doped layer on the second region using alkali etching process; or removing all of the third doped layer and the barrier layer at the outermost side and at least a portion of the second doped layer at the outermost side on the second region by using alkali etching process.

Compared to the prior art, the present disclosure has the following beneficial effects.

The present disclosure removes the mask layer on the non-metal region of the back surface using laser technology, and then removes or thins the tunneling and passivation contact structure on the second region of the back surface using chemical etching process, which ensures that the silicon substrate would not be damaged and the tunneling and passivation contact structure on the first region would not be affected, so that it can take into account the passivation effect and the reduction of parasitic absorption, and improve the efficiency of the cell and the double-side ratio significantly while increasing the process window.

The chemical etching process may further polish the silicon substrate on the second region, thereby increasing the height difference between the portion of the first region and the another portion of the second region and forming a pyramid base having a larger size on the second region, and thereby further increasing the cell efficiency.

By the introduction of the barrier layer on the back surface of the cell, the doping concentration change of the doped layer can be effectively improved during laser processing to avoid damage to the tunneling layer, which further improves the passivation effect. At the same time, the barrier layer has a certain ability to prevent piercing by slurry on the back surface, which helps to reduce the total thickness of the doped layer on the back surface, and improve the open-circuit voltage (Voc) of the cell.

### BRIEF DESCRIPTION OF DRAWINGS

In order to more clearly illustrate technical solutions in embodiments of the present disclosure or the prior art, drawings that need to be used in the description of the embodiments or the prior art will be briefly introduced. Obviously, the drawings in the following description are only some of the embodiments recorded in the present disclosure, and for the person of ordinary skill in the field, other drawings can be obtained according to these drawings without any creative labor.
FIG. 1 is a schematic diagram showing a structure of a solar cell in embodiment 1 of the present disclosure;
FIG. 2 is a schematic diagram showing a local structure at M in FIG. 1;
FIG. 3 is a schematic planar diagram of a second surface of a silicon substrate in embodiment 1 of the present disclosure;
FIG. 4 is a schematic planar diagram of the second surface and a second electrode in embodiment 1 of the present disclosure;
FIGS. 5a to5j are flow charts of a preparation process of the solar cell in embodiment 1 of the present disclosure;
FIG. 6 is a schematic diagram showing a structure of a solar cell in embodiment 2 of the present disclosure;
FIG. 7 is a schematic diagram of a local structure at N in FIG. 6;
FIG. 8 is a schematic planar graph of the second surface of the silicon substrate in embodiment 3 of the present disclosure
FIG. 9 is a schematic diagram of a local structure at A in FIG. 8;
FIGS. 10a to 10j are flow charts of an preparation process of the solar cell in embodiment 3 of the present disclosure;
FIG. 11 is a schematic diagram showing a structure of a solar cell in embodiment 4 of the present disclosure;
FIG. 12 is a schematic diagram showing a local structure at B in FIG. 11;
FIG. 13 is a schematic diagram showing a structure of a solar cell in embodiment 5 of the present disclosure;
FIG. 14 is a schematic diagram showing a local structure at C in FIG. 13;
FIG. 15 is a schematic diagram showing a structure of a solar cell in embodiment 6 of the present disclosure;
FIG. 16 is a schematic diagram showing a local structure at D in FIG. 15;
FIG. 17 is an SEM image of a texture with a pyramid structure in embodiment 1 of the present disclosure;
FIG. 18 is an SEM image of a first region on the backlighting face of the silicon substrate in embodiment 1 of the present disclosure;
FIG. 19 shows an SEM image of a second region on the backlighting face of the silicon substrate in Example 1 of the present disclosure.

Reference numbers:
solar cell 100;
silicon substrate 10; first surface S1; second surface S2; first region S21; second region S22; first doped layer 11; tunneling layer 12; second doped layer 13; aluminium oxide layer 21; silicon nitride layer 31; silicon oxide layer 22; silicon nitride layer 32; barrier layer 14; a layer of second doped layer 131; third doped layer 132; mask layer 15; first electrode 41; second electrode 42; first sub-region 101; second sub-region 102; fine grid line 421; first tunneling and passivation contact structure 110; second tunneling and passivation contact structure 120; first passivation structure 130; second passivation structure 140.

### DESCRIPTION OF EMBODIMENTS

In order to better understand the technical solutions in the present disclosure for the person skilled in the field, the technical solutions in the embodiments of the present disclosure will be clearly and completely described below with reference to the drawings in the embodiments of the present disclosure. Obviously, the described embodiments are only a part of the embodiments of the present disclosure, and not all of the embodiments. Based on the embodiments in the present disclosure, all other embodiments obtained by the person of ordinary skills in the field without making any creative labor should fall within the protection scope of the present disclosure.

In the present disclosure, unless otherwise clearly specified and defined, a first feature being "above" or "below" a second feature may refer to a direct contact between the first feature and the second feature, or an indirect contact between the first feature and the second feature through an intermediate medium. Furthermore, the first feature being "on top of", "above" and "on" the second feature may refer to the first feature being directly above or diagonally above the second feature, or may simply refer to the first feature being at a horizontal height higher than that of the second feature. The first feature being "below", "under" and "underneath" the second feature may refer to the first feature being directly below or diagonally below the second feature, or may simply refer to the first feature being at a horizontal height less than that of the second feature.

The present disclosure discloses a solar cell. The solar cell includes a silicon substrate. The silicon substrate includes a first surface and a second surface that are disposed opposite to each other. The second surface includes a first region and a second region, a first tunneling and passivation contact structure is provided on the first region, a second passivation structure is provided on the first region and the second region, and the second passivation structure on the first region is disposed on the first tunneling and passivation contact structure. A height difference H₁ between a portion of a surface of the second passivation structure at a side facing away from the silicon substrate on the first region and another portion of the surface of the second passivation structure at the side facing away from the silicon substrate on the second region is 0.01µm to 8µm, and/or a height difference H₂ between a portion of a surface of the second passivation structure at a side facing towards the silicon substrate on the first region and another portion of the surface of the second passivation structure at the side facing towards the silicon substrate on the second region is 0.01µm to 8µm.

According to some embodiments of the present application, the first surface is a light-receiving surface, the second surface is a backlighting surface, the first region is a metal region, and the second region is a non-metal region. A thickness of the second passivation structure that is stacked along a direction perpendicular to the backlighting surface of the silicon substrate on the metal region is equal to a thickness of the second passivation structure that is stacked along a direction perpendicular to the backlighting surface of the silicon substrate on the non-metal region, and the stacked structure on the metal region has a thickness greater than a thickness of the stacked structure on the non-metal region.

The present disclosure further discloses a method of preparing the solar cell. The method includes the flowing steps of:
providing a silicon substrate, the silicon substrate including a first surface and a second surface that are disposed opposite to each other, the second surface including a first region and a second region;
preparing a tunneling and passivation contact structure and a mask layer on the second surface;
performing graphical mask opening on the mask layer on the second region using laser processing;
removing all or a portion of the tunneling and passivation contact structure on the second region using a wet etching process to retain the tunneling and passivation contact structure on the first region;
removing the mask layer on the first region to expose the tunneling and passivation contact structure on the first region; and
preparing a second passivation structure on the second surface.
here, a height difference H₁ between a portion of a surface of the second passivation structure at a side facing away from the silicon substrate on the first region and another portion of the surface of the second passivation structure at the side facing away from the silicon substrate on the second region is 0.01µm to 8µm, and/or a height difference H₂ between a portion of a surface of the second passivation structure at a side facing towards the silicon substrate on the first region and another portion of the surface of the second passivation structure at the side facing towards the silicon substrate on the second region is 0.01µm to 8µm.

The present disclosure further discloses a photovoltaic module including the solar cell as described above.

In the present disclosure, the mask layer on the non-metal region on the back surface is removed using laser processing, and then all or a portion of the tunneling and passivation contact structure on the non-metal region of the back surface is removed using the chemical etching process, therefore the passivation effect and the reduction of parasitic absorption are taken into account at the same time, and thus the cell efficiency and double-side ratio can be significantly improved at the same time of the technology window being improved.

The present disclosure is further described below in connection with specific examples.

### Embodiment 1:

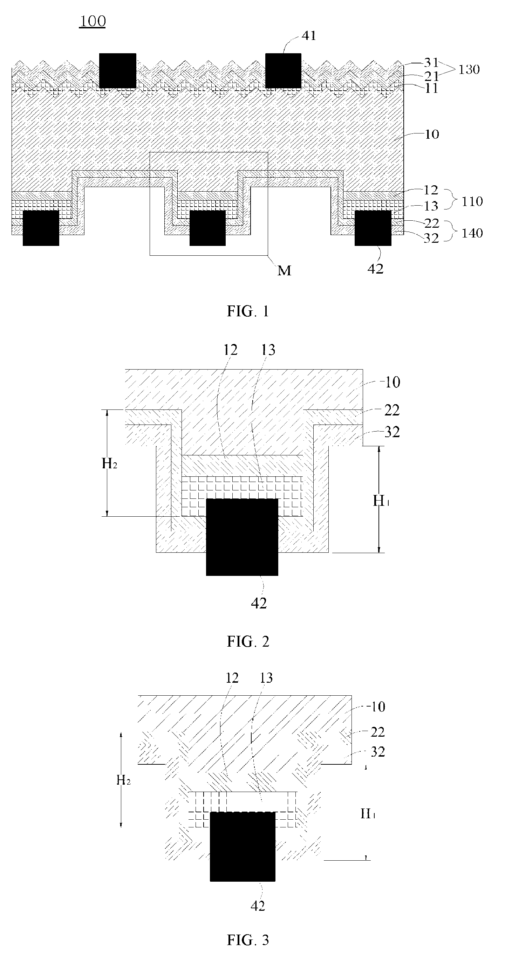

FIG. 1 and FIG. 2 are schematic diagrams showing a structure of a solar cell in this embodiment. The solar cell is a TOPCon cell and includes a silicon substrate 10. The silicon substrate 10 includes a first surface S1 and a second surface S2 that are disposed opposite to each other. The second surface S2 includes a first region S21 and a second region S22, the first surface S1 is a front surface (i.e., a light-receiving surface) of the silicon substrate 10, the second surface S2 is the back surface (i.e., a backlighting surface) of the silicon substrate 10, the first region S21 is a metal region of the back surface, and the second region S22 is a non-metal region of the back surface.

Optionally, a thickness of a second passivation structure 140 that is disposed on the first region S21 along a direction perpendicular to the second surface S2 of the silicon substrate 10 is equal to a thickness of the second passivation structure 140 that is disposed on the second region S22 along the direction perpendicular to the second surface S2 of the silicon substrate 10. The stacked structure on the first region S21 has a thickness greater than a thickness of the stacked structure on the second region S22. The stacked structure on the first region S21 has a thickness greater by 0.05µm to 8µm or 3µm to 6µm than a thickness of the stacked structure on the second region S22.

The silicon substrate 10 in this embodiment is an N-type silicon substrate with an electrical resistivity of 0.35Ω•cm to 7Ω•cm, preferably 0.5Ω•cm to 3.5Ω•cm.

Further, the first surface S1 of the silicon substrate 10 is formed with a texture with a pyramid structure through an alkali texturing process. The pyramid structure is in the shape of a truncated pyramid, such as a triangular frustum, a quadrilateral frustum, etc.. The pyramid size is defined as an average width of the bottom of the truncated pyramid. For example, in the case of a quadrilateral frustum, its bottom is roughly square, and the pyramid size is an length of a side of the square.

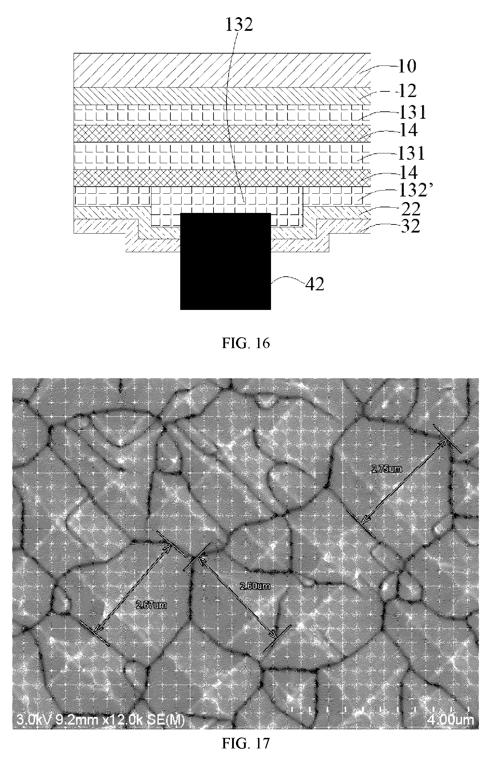

The pyramid size in this embodiment is 0.5µm to 3µm. Referring to FIG. 17 showing an SEM image of the texture with a pyramid structure in this embodiment, three pyramid sizes are indicated as 2.67µm, 2.60µm, and 2.75µm respectively, and the average value of all pyramid sizes is about 2.7µm.

The first region S21 and the second region S22 in the second surface S2 both have a polished surface obtained by polishing the texture with the pyramid structure. The silicon substrate 10 in this embodiment is sunken on the second region S22, and a size of a pyramid base of the pyramid structure on the first region S21 is smaller than that on the second region S22. In the alkali polishing process, the texture with the pyramid structure on the back surface of the silicon substrate 10 is polished to form a pyramid base, and the pyramid base is a base that obtained by polishing the texture with the pyramid structure. The shape of the pyramid base may be a triangle, a quadrangle, etc., and the size of the pyramid base is defined as the average width of the pyramid base graphic. In the case of a square pyramid base, for example, the size of the pyramid base is an average side length of the square.

The pyramid base formed during the alkali polishing process has a size larger than the pyramid size. A deeper etching depth causes a larger size of the pyramid base. The size of the pyramid base in the first region S21 in this embodiment is 3µm to 20µm, preferably 8µm to 15µm, and the size of the pyramid base in the second region is 3µm to 50µm, preferably 15µm to 30µm.

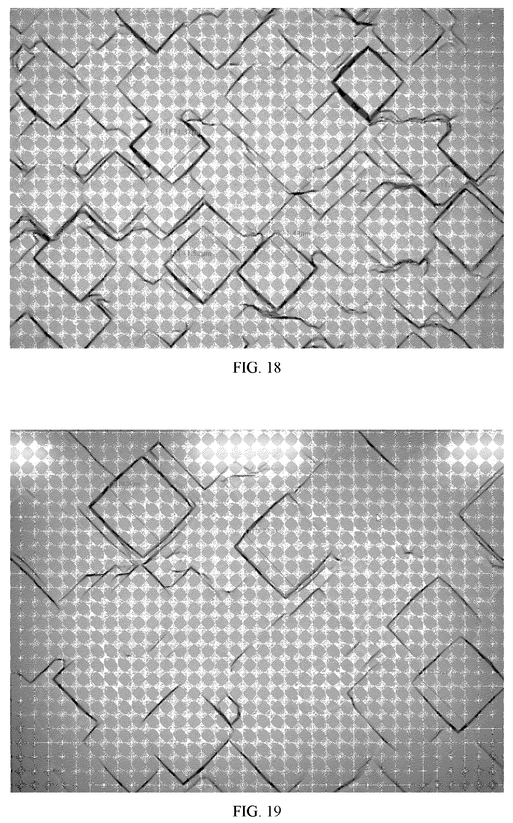

Referring to FIG. 18 which shows an SEM image on the first region S21 in this embodiment, the sizes of the pyramid bases indicated in the figure are 11.37µm, 11.52µm, 11.44µm, 11.53µm, and 11.13µm respectively, and the average size of the pyramid bases in the first region S21 is about 11.4µm. Referring to FIG. 19 which shows an SEM image on the second region S22 in this embodiment, the etching depth of the second region S22 is deeper, and the size of the pyramid base formed is larger. For example, the sizes of the pyramid bases indicated in FIG. 19 are 20.30µm, 20.23µm, and 19.29µm respectively, and the average size of the pyramid bases in the second region S22 is about 20µm.

In this embodiment, a first doped layer 11 is formed on the first surface S1 of the silicon substrate 10 by a diffusion technology or a PECVD technology. For example, the first doped layer 11 is a P-type doped layer (i.e., a P+ emitter) formed by a boron doping process, and has a doping concentration of 1E18cm⁻³ to 5E19cm⁻³, a square resistance of 100Ω/sq to 500Ω/sq, preferably 200Ω/sq to 400Ω/sq.

Referring to FIG. 1 in combine with FIG. 2, in this embodiment, a first tunneling and passivation contact structure 110 is provided on the first region S21 of the second surface S2 of the silicon substrate 10, the first tunneling and passivation contact structure 110 includes a tunneling layer 12 and a second doped layer 13 stacked in sequence.

The tunneling layer 12 is any one of a silicon oxide (SiO_{X}) layer and a silicon oxynitride (SiO_{X}N_{Y}) layer, or any combination thereof. The tunneling layer 12 is preferably the silicon oxide layer. The tunneling layer 12 has a thickness of 0.5nm to 3nm, preferably 1.5nm to 2.5nm. The second doped layer 13 is a phosphorus doped polysilicon layer with a doping concentration of 2E20cm⁻³ to 3E21cm⁻³, preferably 5E20cm⁻³ to 2E21cm⁻³. The second doped layer 13 has a thickness of 1nm to 150nm, preferably 50nm to 100nm.

In addition, in this embodiment, a first passivation structure 130 and a second passivation structure 140 are respectively disposed on the first surface S1 and the second surface S2 of the silicon substrate 10.

Specifically, the first passivation structure 130 is disposed on the first doped layer 11, and includes an aluminium oxide (AlO_{X}) layer 21 and a silicon nitride (SiN_{X}) layer 31 stacked in sequence. The aluminium oxide layer 21 has a thickness of 3nm to 10nm, preferably 4nm to 8nm. The silicon nitride layer 31 has a thickness of 60nm to 100nm, preferably 70nm to 90nm.

The second passivation structure 140 is disposed on the second region S22 and is disposed on a surface of the second doped layer 13. The second passivation structure 140 includes any one of a silicon oxide (SiO_{X}) layer, an aluminium oxide (AlO_{X}) layer and a silicon nitride (SiN_{X}) layer, or any combination thereof. For example, the second passivation structure 140 in this embodiment includes a silicon oxide (SiO_{X}) layer 22 and a silicon nitride (SiN_{X}) layer 32 stacked in sequence. The silicon oxide layer has a thickness of 1nm to 30nm, and the silicon nitride layer has a thickness of 60nm to 100nm, preferably 70nm to 90nm.

Since the silicon substrate 10 is sunken on the second region S22 in this embodiment, there is a height difference between a portion of the first region S21 and another portion of the second region S22. Referring to FIG. 2, a height difference between a portion of a surface of the second passivation structure 140 at a side facing away from the silicon substrate 10 (i.e., an outer side surface of the silicon nitride layer 32) on the first region S21 and another portion of the surface of the second passivation structure 140 at the side facing away from the silicon substrate 10 (i.e., the outer side surface of the silicon nitride layer 32) on the second region S22 is H₁, a height difference between a portion of a surface of the second passivation structure 140 at a side facing towards the silicon substrate 10 (i.e., an inner side surface of the silicon oxide layer 22) on the first region S21 and another portion of the surface of the second passivation structure 140 at the side facing towards the silicon substrate 10 (i.e., the inner side surface of the silicon oxide layer 22) on the second region S22 is H₂.

In the first region S21, the tunneling layer 12 and the second doped layer 13 are stacked, thus the height difference H₂ is a sum of a sunk depth of the second region S22, a thickness of the tunneling layer 12 and and a thickness of the second doped layer 13, and has a value of 0.05µm to 8µm, preferably 3µm to 6µm. For example, the sum of the thickness of the tunneling layer 12 and the thickness of the second doped layer 13 in this embodiment is about 100nm (0.1µm), the height difference H₂ is about 4µm, and the sunk depth of the second region S22 is about 3.9µm.

The silicon oxide layer 22 and the silicon nitride layer 32 in this embodiment are obtained by frontal deposition using a PECVD technology, so that the silicon oxide layer 22 and the silicon nitride layer 32 on the first region S21 and the second region S22 have an equal thickness, and thus the height difference H₁ and the height difference H₂ are equal to each other. In other embodiments, when the thickness of the second passivation structure 140 on the first region S21 and the thickness of the second passivation structure 140 on the second region S22 are not equal to each other, the height difference H₁ and the height difference H₂ are also not equal.

In the present disclosure, the second passivation structure 140 disposed on the first region (e.g., the metal region) S21 along a direction perpendicular to the second surface (e.g., the backlighting surface) of the silicon substrate 10 and the second passivation structure 140 disposed on the second region (e.g., the non-metal region) S22 along a direction perpendicular to the second surface (e.g., the backlighting surface) of the silicon substrate 10 are of equal thickness (taking no account of the second passivation structure 140 disposed on the sidewall of the first tunneling and passivation contact structure 110). At this time, the height difference H₂ between the portion of the surface of the second passivation structure at the side facing towards the silicon substrate on the first region and the another portion of the surface of the second passivation structure at the side facing towards the silicon substrate on the second region is 0.01µm to 8µm, and the height difference H between the portion of the surface of the second passivation structure at the side facing away from the silicon substrate on the first region S21 and the another portion of the surface of the second passivation structure at the side facing away from the silicon substrate on the second region S22 is 0.01µm to 8µm,

In another embodiment of the present disclosure, the second passivation structure 140 includes a silicon oxide layer, an aluminium oxide layer, and a silicon nitride layer stacked in sequence. The silicon oxide layer has a thickness of 0.1nm to 3nm, the aluminium oxide layer has a thickness of 3nm to 10nm, preferably 4nm to 8nm, and the silicon nitride layer has a thickness of 60nm to 100nm, preferably 70nm to 90nm.

In addition, in this embodiment, a first electrode 41 is disposed on the first surface S1 of the silicon substrate 10 and directly contacts with the first doped layer 11; and a second electrode 42 is disposed on the second surface S2 of the silicon substrate 10, specifically in the first region S21 of the second surface S2, and directly contacts with the second doped layer 13.

Referring to FIG. 3, the first region S21 in this embodiment includes a plurality of first sub-regions 101 that are distributed in parallel and equidistantly spaced apart, the second region S22 includes a plurality of second sub-regions 102 that are distributed in parallel and equidistantly spaced apart, and the first sub-region 101 and the second sub-region 102 are alternately distributed. The first sub-region 101 has a width smaller than a width of the second sub-region 102. For example, a ratio of the widths of the first and second sub-regions 101 and 102 may be 1:(5~20). Preferably, the first region S21 has a width of 20µm to 600µm, and an area of the first region S21 accounts for about 10% of an area of the entire second surface S2.

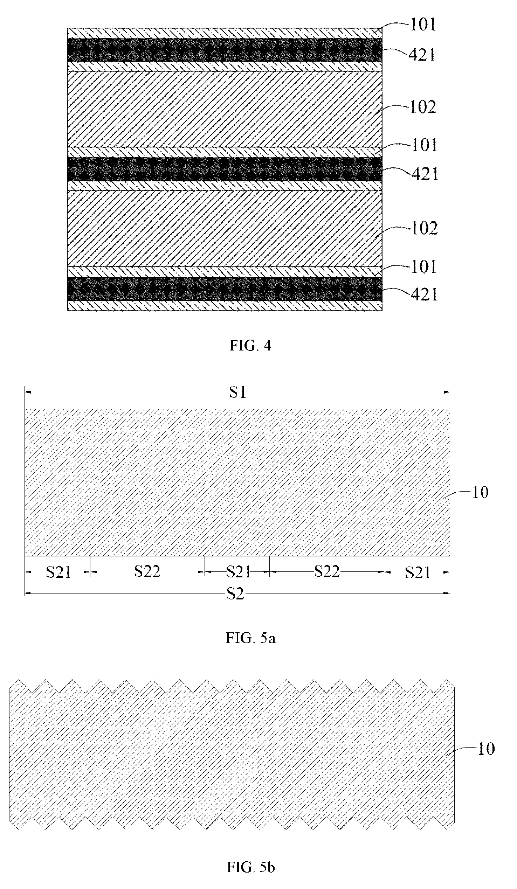

As shown in FIG. 4, the second electrode 42 is a grid line electrode that includes at least a plurality of fine grid lines 421 distributed in parallel, and the first sub-region 101 has a width greater than or equal to a width of the fine grid line 421. Optionally, the second electrode 42 may further include a plurality of main grid lines (not shown) distributed perpendicular to the fine grid lines 421.

A 210 TOPCon cell is taken as an example. The cell has a size of 203.3 96±15mm, and the number of the fine grid lines 421 is 230, the fine grid line 421 has a width of 15µm to 100µm, and a spacing between adjacent fine grid lines 421 is 0.9074+0.015mm. The spacing between adjacent first sub-regions 101 is equal to the spacing between the adjacent fine grid lines 421, and there is one fine grid line 421 distributed in each first sub-region 101. The first sub-region 101 has a width greater than the width of the fine grid line 421. The first sub-region has a width of 50µm to 150µm. For example, a width of the fine grid line is 40µm, and a width of the first sub-region is 80µm.

The method of preparing the solar cell in this embodiment specifically includes the following steps.

### 1. Double-side texturing

Referring to FIG. 5a, a silicon substrate 10 is provided. The silicon substrate 10 includes a first surface S1 and a second surface S2 that are disposed opposite to each other. The second surface S2 includes a first region S21 and a second region S22. The first surface S1 is a front surface (i.e., a light-receiving surface) of the silicon substrate 10, and the second surface S2 is a back surface (i.e., a backlighting surface) of the silicon substrate 10. The first region S21 is a metal region of the back surface, the second region S22 is a non-metal region of the back surface.

The silicon substrate 10 in this embodiment is an N-type silicon substrate with an electrical resistivity of 0.35Ω•cm to 7Ω•cm, preferably 0.5Ω•cm to 3.5Ω•cm.

Referring to FIG. 5b, the first surface S1 and the second surface S2 of the silicon substrate 10 in this embodiment are formed with a texture with a pyramid structure through an alkali texturing process, and the pyramid has a size of 0.5µm to 3µm.

### 2. Boron diffusion

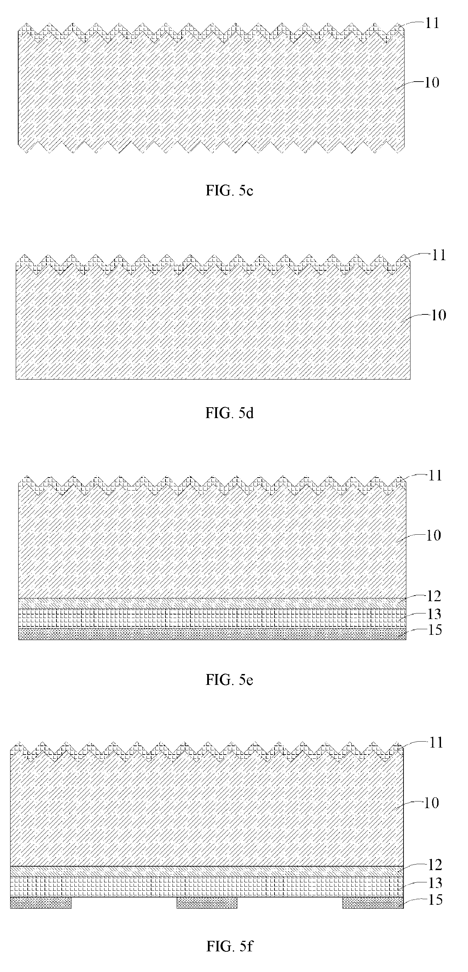

Referring to FIG. 5c, a first doped layer (i.e., a P+emitter) 11, which is P-type doped, is formed on the first surface S1 of the silicon substrate 10 by a boron diffusion process. Specifically, diffusion is performed in a high-temperature furnace tube using a boron source deposition and propulsion method. The first doped layer 11 obtained after this diffusion has a doping concentration of 1E18cm⁻³ to SE19cm⁻³, and has a square resistance of 100Ω/sq to 500Ω/sq, preferably 200Ω/sq to 400Ω/sq. In the boron diffusion process, a Boron-Silicate Glass (BSG, not shown) is formed on the second surface S2 of the silicon substrate 10.

In other embodiments, the first doped layer 11 may be prepared using a PECVD process. Firstly, a layer of boron-doped amorphous silicon with a thickness of 10nm to 100nm is deposited on the first surface S1 using the PECVD process, and then a P-type doped polycrystalline silicon layer is formed after high-temperature oxidizing and annealing.

### 3. Back surface polishing

Referring to FIG. 5d, the silicon substrate 10 obtained after boron diffusion firstly passes through a single-sided chain device to remove the silicon oxide on the back surface using a hydrofluoric acid solution. and then the back surface is subject to alkali polishing to remove edge knots and a back surface wrapping plating (BSG), and finally cleaning is performed.

During the alkali polishing process, the texture with the pyramid structure on the back surface of the silicon substrate 10 is polished to form a pyramid base, which is a base that is left after polishing the texture with the pyramid. The pyramid base on the back surface of the silicon substrate 10 obtained after alkali polishing in this embodiment has a size of 3µm to 20µm, preferably 8µm to 15µm.

### 4. Preparation of tunneling and passivation contact structure on the back surface

As shown in FIG. 5e, a tunneling layer 12, a second doped layer 13, and a mask layer 15 stacked in sequence are prepared on the second surface S2.

As an example, in this embodiment, a silicon oxide layer as a tunneling layer is firstly deposited on the back surface using a PECVD process. The silicon oxide layer has a thickness of 0.5nm to 3nm, preferably 1.5nm to 2.5nm.

Then, a phosphorus-doped amorphous silicon layer is deposited using a PECVD process, with a doping concentration of 2E20cm⁻³ to 3E21cm⁻³, preferably 5E20cm⁻³ to 2E21cm⁻³. The phosphorus-doped amorphous silicon layer has a thickness of 1nm to 150nm, preferably 50nm to 100nm. Finally, a mask layer 15 is deposited. The mask layer 15 is any one of a silicon oxide (SiO_{X}) layer, a silicon nitride oxide (SiO_{X}N_{Y}) layer and a silicon nitride (SiN_{X}) layer, or any combination thereof. The mask layer 15 has a thickness of 1nm to 100nm, preferably 5nm to 30nm.

### 5. Annealing

The silicon substrate 10 with the tunneling and passivation contact structure deposited on the back surface is placed in a high-temperature annealing furnace for high-temperature annealing. The annealing temperature is 850°C to 950°C, preferably 89°C to 920°C. Phosphorus is activated during the annealing process so as to convert the doped amorphous silicon layer into a doped polycrystalline silicon layer.

### 6. Mask opening using laser

As shown in FIG. 5f, graphical mask opening is performed on the mask layer 15 on the second region (non-metal region) S22 using laser processing.

The energy required for mask opening using the laser is affected by the thickness of the mask layer 15. In this embodiment, the laser may be a green picosecond laser or a violet picosecond laser. a laser power of the laser is 0.3W to 25W, preferably 0.3W to 5W. A laser frequency is 100kHz to 1000kHz, preferably 300kHz to 600kHz. A laser scanning rate is 10000mm/s to 100000mm/s, preferably 10000mm/s to 60000mm/s. The number of times of laser processing is 1 to 100, preferably 1 to 10.

### 7. Wet etching

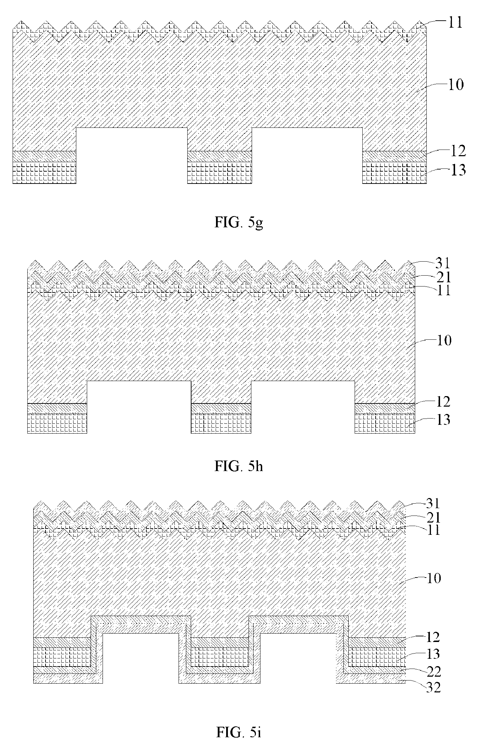

Referring to FIG. 5g, a wet etching process is used to remove the second doped layer 13, the tunneling layer 12, and a portion of the silicon substrate 10 that are on the second region S22, and the tunneling layer 12 and the second doped layer 13 on the first region S21 are retained.

Firstly, hydrofluoric acid is used to remove PSG on the front surface and at edges. Then, an alkali etching process is used to remove wrapping plating on the front surface and at edges, as well as the tunneling layer 12, the second doped layer 13, and a portion of the silicon substrate 10 that are on the second region S22. The etching solution is made of ingredients that are sodium hydroxide/potassium hydroxide, additives and pure water. The etching temperature is 50°C to 90°C, preferably 60°C to 80°C. The etching time is 100s to 500s, preferably 200s to 300s. The pyramid base on the second region S22 of the silicon substrate 10 after alkali etching has a size of 3µm to 50µm, preferably 15µm to 30µm. Finally, hydrofluoric acid is used to remove the BSG on the front surface and the mask layer 15 on the first region S21 of the back surface, and RCA cleaning is performed.

After the wet etching process is performed, a height difference between a portion of the surface of the second doped layer 13 facing away from the silicon substrate 10 and another portion of the second surface on the second region S22 is 0.05µm to 8µm, preferably 3µm to 6µm.

### 8. Preparing a first passivation structure

Referring to Fig. 5h, firstly, an aluminium oxide layer 21 is deposited on the first surface using an ALD process. The aluminium oxide layer 21 has a thickness of 3nm to 10nm, preferably 4nm to 8nm. Then, a silicon nitride layer 31 is deposited on a surface of the aluminium oxide layer using a PECVD process. The silicon nitride layer 31 has a thickness of 60nm to 100nm, preferably 70nm to 90nm.

### 9. Preparing a second passivation structure

Referring to FIG. 5i, firstly, a silicon oxide layer 22 and a silicon nitride layer 32 are deposited on the second region and the surface of the second doped layer using the PECVD process. The silicon oxide layer 22 has a thickness of 0.1nm to 3nm. The silicon nitride layer 32 has a thickness of 60nm to 100nm, preferably 70nm to 90nm.

In other embodiments, firstly, a silicon oxide layer and an aluminium oxide layer are deposited on the second region S22 and the surface of the second doped layer 13 by using an ALD process. During the deposition process of the silicon oxide layer, H₂O is introduced, a deposition temperature is 180°C to 300°C, and the silicon oxide layer has a thickness of 0.1nm to 3nm. During the deposition process of the aluminium oxide layer, TMA and H₂O are introduced, a deposition temperature is 180°C to 300°C, and the aluminium oxide layer has a thickness of 3nm to 10nm, preferably 4nm to 8nm. Then, a silicon nitride layer is deposited on the surface of the aluminium oxide layer using the PECVD process. The silicon nitride layer has a thickness of 60nm to 100nm, preferably 70nm to 90nm.

It should be understood that in this embodiment, the second passivation structure is prepared on the second region S22 and the surface of the second doped layer 13, and the second passivation structure would be synchronously formed on sidewalls of the tunneling layer 12 and the second doped layer 13 during the deposition process. The second passivation structure on the sidewall has a thickness (about 90nm) much smaller than the width (20µm to 600µm) of the tunneling layer 12 and the second doped layer 13.

### 10. Printing metal electrode

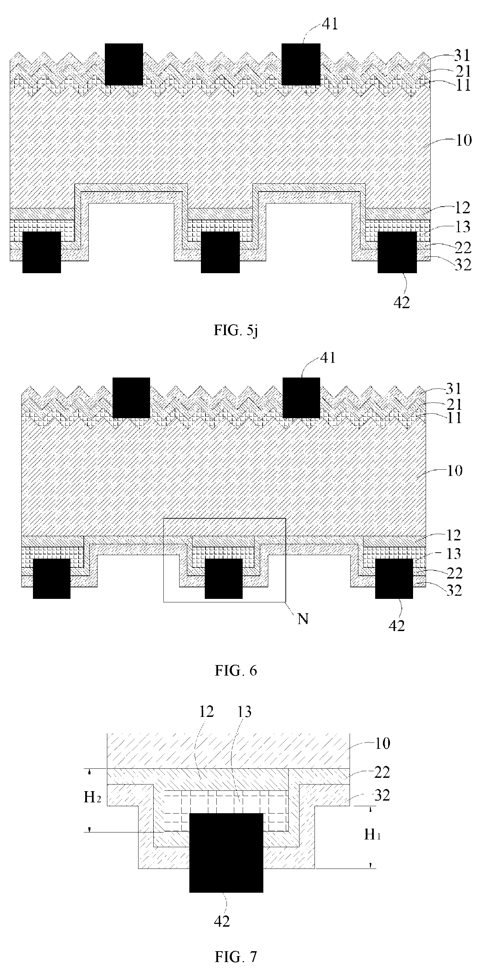

Referring to FIG. 5j, a first electrode 41 and a second electrode 42 are printed, by a screen-printing process, on the front surface and the back surface respectively, and then sintering and optical or electric injection are performed to form an ohmic contact.

The first electrode 41 and the second electrode 42 are grid line electrodes in the prior art, and each typically include a main grid line and a fine grid line. It is worth noting that since the fine grid line in the second electrode 42 needs to be printed on the first region, the width of the first sub-region needs to be larger than the width of the fine grid line in the second electrode 42, so that correct orientation of the fine grid line can be realized.

The TOPCon cell can be prepared by the above steps, and finally the cell is tested, sorted and put in storage.

### Embodiment 2:

FIG.6 and FIG.7 are schematic diagrams showing a structure of a solar cell in this embodiment. The structure and preparation process of the solar cell in this embodiment is roughly the same as that of the above embodiment 1, and have the following differences.

In this embodiment, the first region S21 and the second region S22 on the second surface S2 of the silicon substrate 10 are flush with each other, and the size of the pyramid base on the both regions is 3µm to 20µm, preferably 8µm to 15µm. The height difference between the portion of the surface of the second doped layer 13 facing away from the silicon substrate 10 and the another portion of the second surface (i.e., backlighting surface) of the second region (i.e., a non-metal region) S22 is equal to the height difference between the portion of the surface of the second passivation structure 140 at a side facing away from the silicon substrate 10 on the first region (i.e., the metal region) S21 and the another portion of the surface of the second passivation structure 140 at the side facing away from the silicon substrate 10 on the second region (i.e., the non-metal region) S22. In this way, the height difference H₁ and the height difference H₂ on both the first region S21 and the second region S22 are the sum of the thickness of the tunneling layer 12 and the thickness of the second doped layer 13, and has a value preferably of 0.05µm to 0.1µm.

Accordingly, in the preparation method of the solar cell of the present embodiment, by controlling the process parameters, the alkali etching process in the wet etching process removes only the second doped layer 13 on the second region S22 without removing the silicon substrate 10. In addition, the hydrofluoric acid is used to remove the mask layer and the tunneling layer 12 on the second region S22 synchronously.

### Embodiment 3:

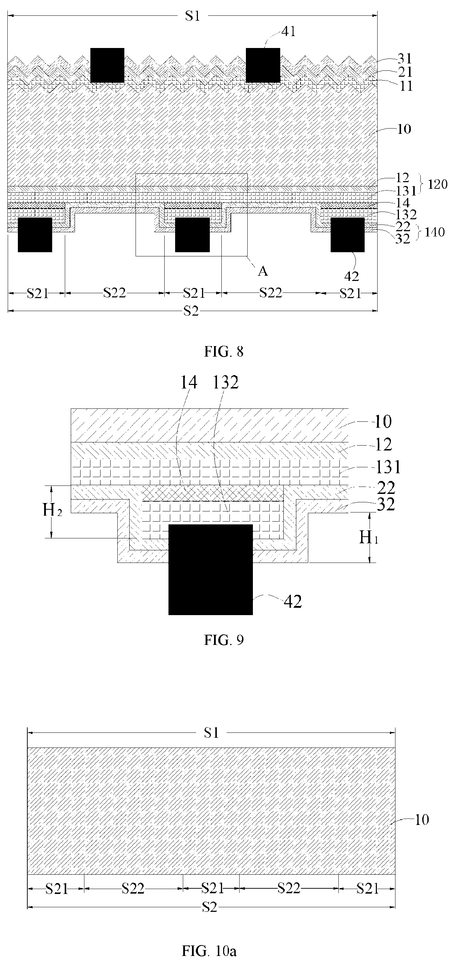

FIG. 8 and FIG. 9 are schematic diagrams showing a structure of a solar cell in this embodiment. The solar cell is a TOPCon cell. The structure of the silicon substrate 10 and the structure on the first surface S1 (i.e., the front or light-receiving surface) are identical to those of the embodiment 1, and description thereof will not be repeated here.

This embodiment is different from the embodiment 1 in the following contents. A first tunneling and passivation contact structure 110 and a second tunneling and passivation contact structure 120 are respectively provided on the first region S21 and the second region S22 of the second surface S2 of the silicon substrate 10.

The first tunneling and passivation contact structure 110 on the first region S21 includes a tunneling layer 12, one second doped layer 131, one barrier layer 14, and a third doped layer 132 stacked in sequence. Specifically, the tunneling layer 12 is any one of a silicon oxide (SiO_{X}) layer and a silicon oxynitride (SiO_{X}N_{Y}) layer, or any combination thereof. The tunneling layer 12 is preferably a silicon oxide layer. The tunneling layer 12 has a thickness of 0.5nm to 3nm, preferably 1.5nm to 2.5nm. The barrier layer 14 is any one of a silicon oxide (SiO_{X}) layer and a silicon carbide layer, or any combination thereof. The barrier layer 14 is preferably a silicon oxide (SiO_{X}) layer. The barrier layer has a thickness of 0.5nm to 3nm, preferably 1.5nm to 2.5nm.

The second doped layer 131 and the third doped layer 132 in this embodiment have a same doping type as that of the silicon substrate 10. Preferably, the third doped layer 132 has a surface doping concentration greater than a surface doping concentration of the second doped layer 131; at the same time, the third doped layer 132 has a thickness greater than a thickness of the second doped layer 131. A total thickness of the second doped layer 131 and the third doped layer 132 are 50nm to 150nm, preferably 60nm to 100nm.

For example, the second doped layer 131 in this embodiment is a phosphorus doped polycrystal silicon layer, has a surface doping concentration of 1E20cm⁻³ to 9E20cm⁻³, preferably 3E20cm⁻³ to 5E20cm⁻³, and has a thickness of 1nm to 100nm, preferably 1nm to 50nm. The third doped layer 132 is a phosphorus doped polycrystal silicon layer, has a surface doping concentration of 2E20cm⁻³ to 3E21cm⁻³, preferably 5E20cm⁻³ to 2E21cm⁻³, and has a thickness of 1nm to 150nm, preferably 50nm to 100nm.

The second tunneling and passivation contact structure 120 on the second region S22 includes a tunneling layer 12 and one second doped layer 131 stacked in sequence, the tunneling layer 12 and the second doped layer 131 are identical to the tunneling layer 12 and the second doped layer 131 on the first region S21, and description thereof will not be repeated here.

In this embodiment, a first passivation structure and a second passivation structure are disposed on the first surface S1 and the second surface S2 of the silicon substrate 10 respectively. The first passivation structure and the second passivation structure are identical to those of the embodiment 1, and description thereof will not be repeated here.

In addition, the first electrode 41 in this embodiment is disposed on the first surface S1 of the silicon substrate 10 and directly contacts with the first doped layer 11. The second electrode 42 is disposed on the second surface S2 of the silicon substrate 10, specifically in the first region S21 of the second surface S2, and directly contacts with the third doped layer 132.

In this embodiment, since the first tunneling and passivation contact structure and the second tunneling and passivation contact structure are disposed on the first region S21 and the second region S22 respectively, and the heights of the two tunneling and passivation contact structures are different, a height difference between the first region (i.e., the metal region S21) and the second region (i.e., the non-metal region S22), that is, a height difference between a surface of the third doped layer 132 on the first region ( i.e., the metal region S21) facing away from the silicon substrate 10 and a surface of the second doped layer 131 on the second region (i.e., the non-metal region S22) facing away from the silicon substrate 10, is a height difference between a portion of a surface at a side of the second passivation structure facing away from the silicon substrate 10 on the first region (i.e., the metal region S21) and another portion of the surface at the side of the second passivation structure facing away from the silicon substrate 10 on the second region (i.e., the non-metal region S22). In other words, the height difference H₁ and the height difference H₂ on the first region S21 and the second region S22 are both a sum of the thickness of the third doped layer 132 and the thickness of the barrier layer 14, and has a value of 0.01µm to 0.153µm, i.e., 10nm to 153nm, preferably 0.048µm to 0.102µm, i.e., 48nm to 102nm. In this embodiment, when the thickness of the barrier layer 14 is 2nm and the thickness of the third doped layer 132 is 98nm, the height difference H₁ and the height difference H₂ are both 100nm.

The method of preparing the solar cell in this embodiment specifically includes the following steps.

### 1. Double-side texturing

Referring to FIG. 10a, a silicon substrate 10 is provided. The silicon substrate 10 includes a first surface S1 and a second surface S2 that are disposed opposite to each other. The second surface S2 includes a first region S21 and a second region S22. The first surface S1 is a front surface (i.e., a light-receiving surface) of the silicon substrate 10, and the second surface S2 is a back surface (i.e., a backlighting surface) of the silicon substrate 10. The first region S21 is a metal region of the back surface, the second region S22 is a non-metal region of the back surface.

The silicon substrate 10 in this embodiment is an N-type silicon substrate with an electrical resistivity of 0.35Ω•cm to 7Ω•cm, preferably 0.5Ω•cm to 3.5Ω•cm.

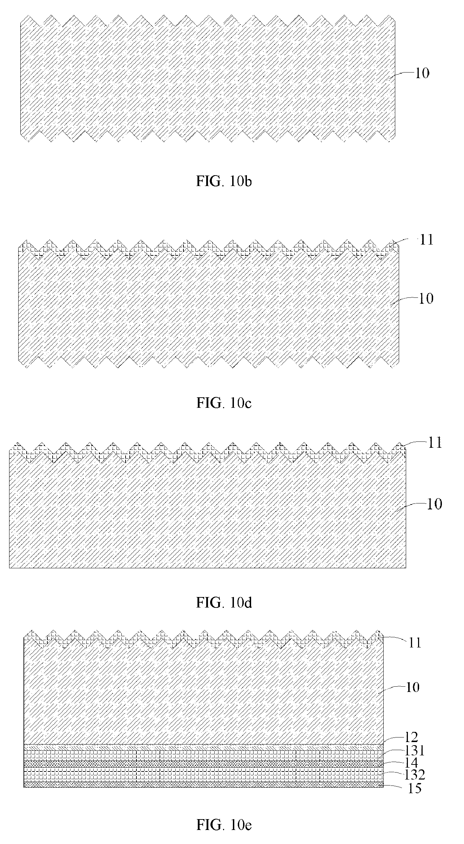

Referring to FIG. 10b, the first surface S1 and the second surface S2 of the silicon substrate 10 in this embodiment are formed with a texture with a pyramid structure through an alkali texturing process, and the pyramid has a size of 0.5µm to 3µm.

### 2. Boron diffusion

Referring to FIG. 10c, a first doped layer (i.e., a P+emitter) 11, which is P-type doped, is formed on the first surface S1 of the silicon substrate 10 by a boron diffusion process. Specifically, diffusion is performed in a high-temperature furnace tube using a boron source deposition and propulsion method. The first doped layer 11 obtained after this diffusion has a doping concentration of 1E18cm⁻³ to 5E19cm⁻³, and has a square resistance of 100Ω/sq to 500Ω/sq, preferably 200Ω/sq to 400Ω/sq. In the boron diffusion process, a BSG (not shown) is formed on the second surface S2 of the silicon substrate 10.

In other embodiments, the first doped layer 11 may be prepared using a PECVD process. Firstly, a layer of boron-doped amorphous silicon with a thickness of 10nm to 100nm is deposited on the first surface S1 using the PECVD process, and then a P-type doped polycrystalline silicon layer is formed after high-temperature oxidizing and annealing.

### 3. Back surface polishing

Referring to FIG. 10d, the silicon substrate 10 obtained after boron diffusion firstly passes through a single-sided chain device to remove the silicon oxide on the back surface using a hydrofluoric acid solution, and then the back surface is subject to alkali polishing to remove edge knots and a back surface wrapping plating (BSG), and finally cleaning is performed.

During the alkali polishing process, the texture with the pyramid structure on the back surface of the silicon substrate 10 is polished to form a pyramid base, which is a base that is left after polishing the texture with the pyramid. The pyramid base on the back surface of the silicon substrate 10 obtained after alkali polishing in this embodiment has a size of 3µm to 20µm, preferably 8µm to 15µm.

### 4. Preparation of tunneling and passivation contact structure on the back surface

As shown in FIG. 10e, a tunneling layer 12, one second doped layer 131, one barrier layer 14, one third doped layer 132, and a mask layer 15 stacked in sequence are prepared on the second surface S2.

As an example, in this embodiment, a silicon oxide layer as a tunneling layer is firstly deposited on the back surface using a PECVD process. The silicon oxide layer has a thickness of 0.5nm to 3nm, preferably 1.5nm to 2.5nm. Then, a phosphorus-doped amorphous silicon layer is deposited using a PECVD process, with a doping concentration of 1E20cm⁻³ to 9E20cm⁻³, preferably 3E20cm⁻³ to 5E20cm⁻³.The phosphorus-doped amorphous silicon layer has a thickness of 1nm to 100nm, preferably 1nm to 50nm. Then, one silicon oxide layer as a barrier layer is deposited using a PECVD process and the silicon oxide layer has a thickness of 0.5nm to 3nm, preferably 1.5nm to 2nm. Then, one phosphorus-doped amorphous silicon layer is deposited using a PECVD process, with a surface doping concentration of 2E20cm⁻³ to 3E21cm⁻³, preferably 5E20cm⁻³ to 2E21cm⁻³, with a thickness of 1nm to 150nm, preferably 50nm to 100nm. Finally, a mask layer 15 is deposited. The mask layer 15 is any one of a silicon oxide (SiO_{X}) layer, a silicon nitride oxide (SiO_{X}N_{Y}) layer and a silicon nitride (SiN_{X}) layer, or any combination thereof. The mask layer 15 has a thickness of 1nm to 100nm, preferably 5nm to 30nm.

### 5. Annealing

The silicon substrate 10 with the tunneling and passivation contact structure deposited on the back surface is placed in a high-temperature annealing furnace for high-temperature annealing. The annealing temperature is 850°C to 950°C, preferably 89°C to 920°C. Phosphorus is activated during the annealing process so as to convert the doped amorphous silicon layer into a doped polycrystalline silicon layer.

### 6. Mask opening using laser

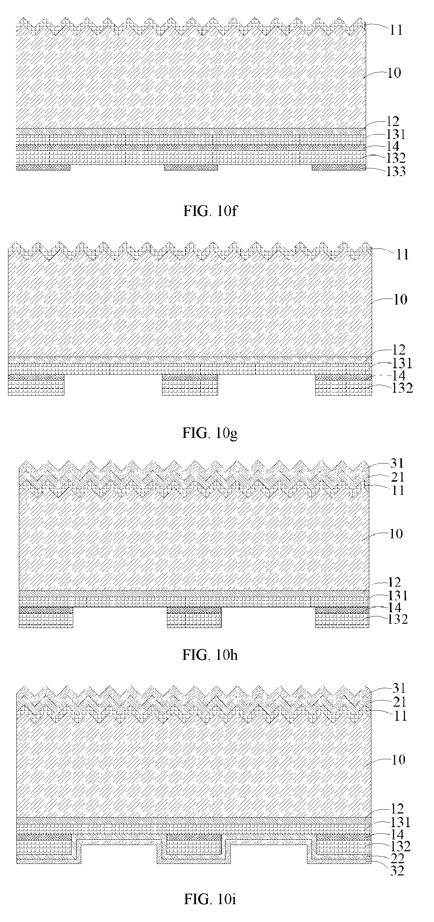

As shown in FIG. 10f, graphical mask opening is performed on the mask layer 15 on the second region (non-metal region) S22 using laser processing.

The energy required for mask opening using the laser is affected by the thickness of the mask layer 15. In this embodiment, the laser may be a green picosecond laser or a violet picosecond laser, a laser power of the laser is 0.3W to 25W, preferably 0.3W to 5W. A laser frequency is 100kHz to 1000kHz, preferably 300kHz to 600kHz. A laser scanning rate is 10000mm/s to 100000mm/s, preferably 10000mm/s to 60000mm/s. The number of times of laser processing is 1 to 100, preferably 1 to 10.

### 7. Wet etching

Referring to FIG. 10g, a wet etching process is used to remove the third doped layer 132 and the barrier layer 14 on the second region S22, and retain the third doped layer 132 and the barrier layer 14 on the first region S21.

Firstly, hydrofluoric acid is used to remove PSG on the front surface and at edges. Then, an alkali etching process is used to remove wrapping plating on the front surface and at edges, as well as the third doped layer 132 on the second region S22. The etching solution is made of ingredients that are sodium hydroxide, potassium hydroxide, additives and pure water. Finally, hydrofluoric acid is used to remove the BSG on the front surface and the mask layer 15 on the first region S21 of the back surface and the barrier layer 14 on the second region S22, and RCA cleaning is performed.

After the wet etching process is performed, the height difference between the portion of the surface of the third doped layer 132 on the first region S21 facing away from the silicon substrate 10 and the another portion of the surface of the second doped layer 131 on the second region S22 facing away from the silicon substrate 10 is 0.01µm to 0.153µm, i.e., 10nm to 153nm.

### 8. Preparing a first passivation structure

Referring to Fig. 10h, firstly, an aluminium oxide layer 21 is deposited on the first surface using an ALD process. The aluminium oxide layer 21 has a thickness of 3nm to 10nm, preferably 4nm to 8nm. Then, a silicon nitride layer 31 is deposited on a surface of the the aluminium oxide layer using a PECVD process. The silicon nitride layer 31 has a thickness of 60nm to 100nm, preferably 70nm to 90nm.

### 9. Preparing a second passivation structure

Referring to FIG. 10i, firstly, a silicon oxide layer 22 and a silicon nitride layer 32 are deposited on the first region S21 and the surface of the second region S22 using the PECVD process. The silicon oxide layer 22 has a thickness of 0.1nm to 3nm. The silicon nitride layer 32 has a thickness of 60nm to 100nm, preferably 70nm to 90nm.

In other embodiments, firstly, a silicon oxide layer and an aluminium oxide layer are deposited on the surface of the first region S21 and on the surface of the second region S22 by using an ALD process. During the deposition process of the silicon oxide layer, H₂O is introduced, a deposition temperature is 180°C to 300°C, and the silicon oxide layer has a thickness of 0.1nm to 3nm. During the deposition process of the aluminium oxide layer, TMA and H₂O are introduced, a deposition temperature is 180°C to 300°C, and the aluminium oxide layer has a thickness of 3nm to 10nm, preferably 4nm to 8nm. Then, a silicon nitride layer is deposited on the surface of the aluminium oxide using the PECVD process. The silicon nitride layer has a thickness of 60nm to 100nm, preferably 70nm to 90nm.

It should be understood that in this embodiment, the second passivation structure is prepared on the surface of the first region S21 and on the surface of the second region S22, and the second passivation structure would be synchronously formed on sidewalls of the first tunneling and passivation contact structure. The second passivation structure on the sidewall has a thickness (about 90nm) much smaller than the width (20µm to 600µm) of the first tunneling and passivation contact structure.

### 10. Printing metal electrode

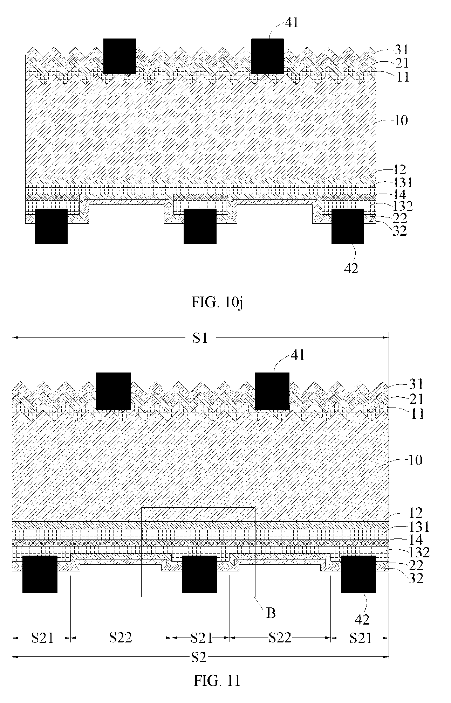

Referring to FIG. 10j, a first electrode 41 and a second electrode 42 are printed, by a screen-printing process, on the front surface and the back surface respectively, and then sintering and optical or electric injection are performed to form an ohmic contact.

The first electrode 41 and the second electrode 42 are grid line electrodes in the prior art, and each typically include a main grid line and a fine grid line. It is worth noting that since the fine grid line in the second electrode 42 needs to be printed on the first region, the width of the first sub-region needs to be larger than the width of the fine grid line in the second electrode 42, so that correct orientation of the fine grid line can be realized.

The TOPCon cell can be prepared by the above steps, and finally the cell is tested, sorted and put in storage.

### Embodiment 4:

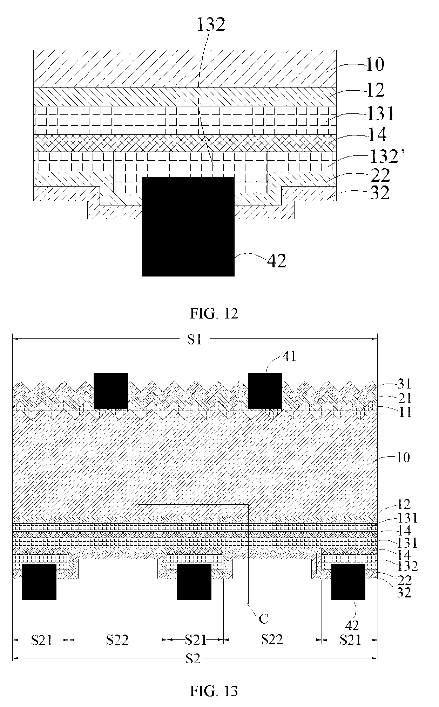

Referring to FIG. 11 in conjunction with FIG. 12, the solar cell in this embodiment is roughly the same as that of embodiment 3, and has the following difference from the Embodiment 3. In this embodiment, a tunneling layer 12, one second doped layer 131, one barrier layer 14 and a third doped layer 132' are stacked in sequence on the second region S22 on the second surface S2 of the silicon substrate 10. The tunneling layer 12, the second doped layer 131, and the barrier layer 14 on the second region S22 are identical to the tunneling layer 12, the second doped layer 131, and the barrier layer 14 on the first region S21, and the third doped layer 132' has the thickness less than the thickness of the third doped layer 132.

The preparation method of the solar cell in this embodiment is also roughly the same as that of example 3, with the difference being that the step 7 i.e., wet etching step is different. In this embodiment, an alkali etching process is used to remove a portion of the third doped layer on the second region S22 and the mask layer on the first region S21 and retain the third doped layer 132 on the first region S21. By controlling the parameters of the alkali etching process, the third doped layer on the second region S22 is thinned rather than completely removed.

In this embodiment, since a portion of the third doped layer 132' on the second region S22 is retained, the acid solution would not corrode the barrier layer 14 on the second region S22 when the pickling process is carried out. Thus, the barrier layer 14 and a portion of the third doped layer 132' are retained on the second region.

Corresponding to the ranges of thickness of the barrier layer 14 and the thickness of the third doped layer 132 in embodiment 3, the height differences H₁ and H₂ between the first region S21 and the second region S22 each are a height difference between the third doped layer 132 and the third doped layer 132', and each have a value less than the thickness of the third doped layer 132, and is 0.01µm to 0.149µm, i.e., 10nm to 149nm, preferably 0.05µm to 0.09µm, i.e., 50nm to 90nm.

As an example, in this embodiment, the barrier layer 14 on the first region S21 has a thickness of about 2nm, the third doped layer 132 has a thickness of 100nm, and the third doped layer 132' retained on the second region S22 has a thickness of about 40nm, so that the difference height H₁ and the height difference H₂ between the first region S21 and the second region S22 each are about 60nm (i.e., 0.06µm).

### Embodiment 5:

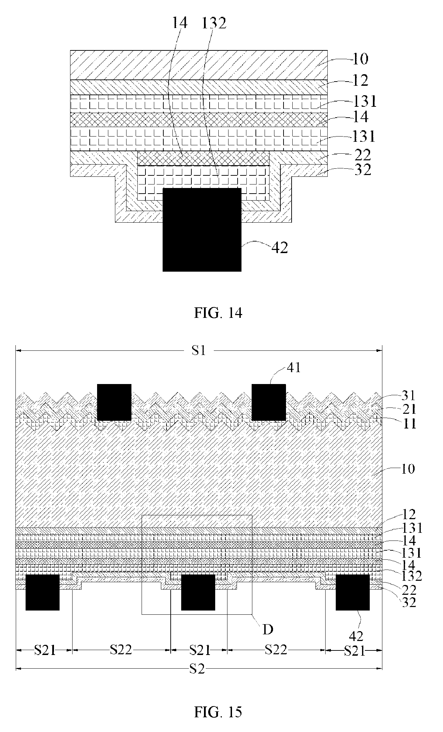

Referring to FIG. 13 in conjunction with FIG. 14, the solar cell in this embodiment is roughly the same as that of embodiment 3, with the difference being that, in this embodiment, the second doped layer 131 and the barrier layer 14 that are alternately stacked are provided on the tunneling layer 12 on the second surface S2 of the silicon substrate 10.

Specifically, in this embodiment, the tunneling layer 12, the second doped layer 131, the barrier layer 14, the second doped layer 131, the barrier layer 14, and the third doped layer 132 are stacked in sequence on the first region S21 of the second surface S2 of the silicon substrate 10, and the tunneling layer 12, the second doped layer 131, the barrier layer 14, and the second doped layer 131 are stacked in sequence on the second region S22 of the second surface S2 of the silicon substrate 10.

The preparation method of the solar cell in this embodiment is also roughly the same as that of example 3, with the difference being that the step 7 i.e., the wet etching step is different. In this embodiment, alkali etching is used to remove the third doped layer 132 on the second region S22, and the acid solution removes the outermost barrier layer 14 on the second region S22 and the mask layer on the first region S21.

Similar to embodiment 3, the height difference H₁ and the height difference H₂ between the first region S21 and the second region S22 in this embodiment depends on a thickness range of the third doped layer 132 and of the outermost barrier layer 14. Details thereof will be omitted here.

### Embodiment 6:

Referring to FIG. 15 in conjunction with FIG. 16, the solar cell in this embodiment is roughly the same as that of embodiment 5, with the difference being that in this embodiment, the tunneling layer 12, the second doped layer 131, the barrier layer 14, the second doped layer 131, the barrier layer 14, and the third doped layer 132' are stacked in sequence on the second region S22 of the second surface S2 of the silicon substrate 10, the third doped layer 132' has a thickness less than a thickness of the third doped layer 132 on the first region S21.

The preparation method of the solar cell in this embodiment is also roughly the same as that of embodiment 5, with the difference being that the step 7 i.e., the wet etching step is different. In this embodiment, the alkali etching process is used to remove a portion of the third doped layer on the second region S22 and the mask layer on the first region S21, and retain the third doped layer 132 on the first region S21. By controlling the parameters of the alkali etching process, the third doped layer on the second region S22 is thinned rather than completely removed.

In this embodiment, since a portion of the third doped layer 132' on the second region S22 is retained, the acid solution would not corrode the barrier layer 14 on the second region S22 when the pickling process is carried out. Thus, the barrier layer 14 and a portion of the third doped layer 132' are retained on the second region.

Similar to embodiment 4, the height difference H₁ and the height difference H₂ between the first region S21 and the second region S22 in this embodiment depends on the range of thicknesses of the third doped layer and the range of thickness of the outermost barrier layer 14. Details thereof will be omitted here.

It should be understood that the number of the second doped layers 131 and the number of the barrier layers 14 are not limited to the number in the above embodiments.

For the thinning scheme of the outermost third doped layer on the second region such as the non-metal region, in both the first region such as the metal region and the second region such as the non-metal region, a tunneling layer, M₁ second doped layers and M₁ barrier layers that are alternately disposed on the tunneling layer, and a third doped layer disposed on the outermost barrier layer are included, and M₁ is a positive integer.

For the removal scheme of the outermost third doped layer on the second region such as the non-metal region, a tunneling layer, M₂ second doped layers and M₂ barrier layers that are alternately disposed on the tunneling layer, and a third doped layer disposed on the outermost barrier layer are included in the first region such as the metal region, a tunneling layer, M₂₋₁ second doped layers and M₂₋₁ barrier layers that are alternately disposed on the tunneling layer are included in the second region such as the non-metal region, and M₂ is a positive integer.

Embodiments for other number of second doped layers and mask layers are not repeated herein by way of examples.

The present disclosure is based on an existing TOPCon cell structure. In this disclosure, a tunneling and passivation contact structure and a mask layer 15 is deposited on the back surface, and then graphical mask opening is performed on the second region S22 (non-metal region) using laser processing, and then the tunneling and passivation contact structure on the second region S22 (non-metal region) is removed or thinned using a wet etching process, so as to provide a new solution for improving efficiency of the TOPCon cell.

The main depositional modes for Poly (polysilicon) include LPCVD and PECVD. From the perspective of production capacity and quartz component costs, compared to LPCVD, PECVD is more suitable for mass production, but the mask on the PE Poly outer layer requires higher energy to be opened. The mask in the non-metal region and Poly (polysilicon) under the mask can be removed by using laser processing. However, with the increase of laser power, an open degree of the mask on the back surface changes as follows, i.e., the mask being unable to be opened → the mask structure being loose → the mask being completely vaporized → the mask and a portion of Poly are vaporized. As the power increases to a certain level, it would cause damage to the silicon substrate, thus reducing the efficiency of the cell.

In the present disclosure, the mask layer 15 on the non-metal region of the back surface is removed using laser processing, and then the tunneling and passivation contact structure on the second region S22 of the back surface is removed or thinned using chemical etching process, which ensures that the silicon substrate 10 would not be damaged and the tunneling and passivation contact structure on the first region S21 would not be affected, so that it can take into account the passivation effect and the reduction of parasitic absorption, and improve the efficiency of the cell and the double-side ratio significantly while increasing the process window.

In embodiment 1, the chemical etching process may further polish the silicon substrate 10 on the second region S22, thereby increasing the height difference between the first region S21 and the second region S22, and forming a pyramid base of a larger size on the second region S22, thereby further increasing the cell efficiency.

In embodiment 3 to embodiment 6, by the introduction of the barrier layer 14 on the back surface of the cell, the doping concentration change of the doped layer can be effectively improved during laser processing to avoid the damage to the tunneling layer, which further improves the passivation effect. At the same time, the barrier layer has a certain ability to prevent piercing by slurry on the back surface, which helps to reduce the total thickness of the doped layer on the back surface, and improve the open-circuit voltage (Voc) of the cell.

It has been tested that the efficiency of the solar cell in the present disclosure can be increased by more than 0.15% as compared to the direct removal of the second doped layer 13 and the tunneling layer 12 on the second region S22 using a laser.

It is apparent to those skilled in the art that the present disclosure is not limited to the details of the exemplary embodiments described above, and that the present disclosure is capable of being realized in other specific forms without departing from the spirit or essential features of the present disclosure. Accordingly, the embodiments should be viewed as exemplary and non-limiting in any point of view, and the scope of the present disclosure is limited by the appended claims rather than by the foregoing description, and is therefore intended to encompass all variations falling within the meaning and scope of the equivalent elements of the claims. Any reference numbers in the claims should not be regarded as limiting the claims to which they relate.

In addition, it should be understood that although this specification is described in accordance with the embodiments, not each embodiment contains only one independent technical solution, and this description of the specification is only for the sake of clarity. The person skilled in the art should take the specification as a whole, and the technical solutions in the various embodiments may be combined appropriately to form other embodiments that can be understood by the person skilled in the art.

## Claims

1. A solar cell (100), comprising a silicon substrate (10), the silicon substrate (10) comprising a first surface (S1) and a second surface (S2) that are disposed opposite to each other, the second surface (S2) comprising a first region (S21) and a second region (S22), a first tunneling and passivation contact structure (110) being provided on the first region (S21), a second passivation structure (140) being provided on the first region (S21) and the second region (S22), the second passivation structure (140) on the first region (S21) being disposed on the first tunneling and passivation contact structure (110), wherein
a height difference H₁ between a portion of a surface of the second passivation structure (140) at a side facing away from the silicon substrate (10) on the first region (S21) and another portion of the surface of the second passivation structure (140) at the side facing away from the silicon substrate (10) on the second region (S22) is 0.01µm to 8µm, and/or
a height difference H₂ between a portion of a surface of the second passivation structure (140) at a side facing towards the silicon substrate (10) on the first region (S21) and another portion of the surface of the second passivation structure (140) at the side facing towards the silicon substrate (10) on the second region (S22) is 0.01µm to 8µm.

2. The solar cell (100) according to claim 1, wherein the second passivation structure (140) on the second region (S22) directly contacts with the second surface (S2) of the silicon substrate (10), and the first tunneling and passivation contact structure (110) on the first region (S21) comprises a tunneling layer (12) and a second doped layer (13) stacked in sequence, the solar cell (100) further comprises a second electrode (42) that is disposed on the first region (S21) and that directly contacts with the second doped layer (13).

3. The solar cell (100) according to claim 2, wherein the height difference H₁ between the portion of the surface of the second passivation structure (140) at the side facing away from the silicon substrate (10) on the first region (S21) and the another portion of the surface of the second passivation structure (140) at the side facing away from the silicon substrate (10) on the second region (S22) is 0.05µm to 8µm or 3µm to 6µm; and/or
the height difference H₂ between the portion of the surface of the second passivation structure (140) at the side facing towards the silicon substrate (10) on the first region (S21) and the another portion of the surface of the second passivation structure (140) at the side facing towards the silicon substrate (10) on the second region (S22) is 0.05µm to 8µm or 3µm to 6µm.

4. The solar cell (100) according to claim 2 or 3, wherein the tunneling layer (12) is any one of a silicon oxide layer and a silicon nitride oxide layer, or any combination thereof; and/or,
the tunneling layer (12) has a thickness of 0.5nm to 3nm or 1.5nm to 2.5nm; and/or
the second doped layer (13) is a doped polysilicon layer with a thickness of 1nm to 150nm or 50nm to 100nm; and/or
the second doped layer (13) has a same doping type as that of the silicon substrate (10), and the second doped layer (13) has a surface doping concentration of 2E20cm⁻³ to 3E21cm⁻³ or 5E20cm⁻³ to 2E21cm⁻³.

5. The solar cell (100) according to any one of claims 1-4, wherein the silicon substrate (10) is sunken on the second region (S22).

6. The solar cell (100) according to any one of claims 1-5, wherein the first region (S21) and the second region (S22) in the second surface (S2) of the silicon substrate (10) has a polished surface obtained by polishing a texture with a pyramid structure, and a size of a pyramid base of the pyramid structure on the first region (S21) is smaller than that on the second region (S22).

7. The solar cell (100) according to claim 6, wherein the size of the pyramid base on the first region (S21) is 3µm to 20µm, and the size of the pyramid base on the second region (S22) is 3µm to 50µm; or
the size of the pyramid base on the first region (S21) is 8µm to 15µm and the size of the pyramid base on the second region (S22) is 15µm to 30µm.

8. The solar cell (100) according to claim 1, wherein a second tunneling and passivation contact structure (120) is provided on the second region (S22), the second passivation structure (140) on the second region (S22) is disposed on the second tunneling and passivation contact structure (120), and the second tunneling and passivation contact structure (120) has a thickness less than a thickness of the first tunneling and passivation contact structure (110).

9. The solar cell (100) according to any one of claims 1-8, wherein a tunneling layer (12), a second doped layer (131), a barrier layer (14) and a third doped layer (132) are provided on the first region (S21), and a tunneling layer (12) and a second doped layer (131) are provided on the second region (S22), the solar cell (100) further comprises a second electrode (42) that is disposed on the first region (S21) and that directly contacts with the third doped layer (132).

10. The solar cell (100) according to claim 9, wherein a tunneling layer (12), one second doped layer (131), one barrier layer (14), and a third doped layer (132) are provided on the first region (S21), and a tunneling layer (12) and one second doped layer (131) are provided on the second region (S22); or
a tunneling layer (12), one second doped layer (131), one barrier layer (14) and a third doped layer (132) are provided on the first region (S21), a tunneling layer (12), one second doped layer (131), one barrier layer (14) and a third doped layer (132) are provided on the second region (S22), and the third doped layer (132) on the second region (S22) has a thickness that is less than that of the third doped layer (132) on the first region (S21); or
a tunneling layer (12), at least two second doped layers (131) and at least two barrier layers (14) that are alternately stacked, and a third doped layer (132) are provided on the first region (S21), and a tunneling layer (12), at least two second doped layers (131) and at least one barrier layer (14) that are alternately stacked are provided on the second region (S22); or
a tunneling layer (12), at least two second doped layers (131) and at least two barrier layers (14) that are alternately stacked and a third doped layer (132) are provided on the first region (S21), a tunneling layer (12), at least two second doped layers (131) and at least two barrier layers (14) that are alternately stacked and a third doped layer (132) are provided on the second region (S22), the third doped layer (132) on the second region (S22) has a thickness that is less than that of the third doped layer (132) on the first region (S21).

11. The solar cell (100) according to claim 8, wherein the first tunneling and passivation contact structure (110) comprises a tunneling layer (12) and at least one doped layer that are disposed on the first region (S21), the second tunneling and passivation contact structure (120) comprises a tunneling layer (12) and at least one layer doped layer that are disposed on the first region (S21), and a total thickness of the at least one doped layer on the first region (S21) is greater than a total thickness of the at least one doped layer on the second region (S22).

12. The solar cell (100) according to any one of claims 8-11, wherein the height difference H₁ between the portion of the surface of the second passivation structure (140) at the side facing away from the silicon substrate (10) on the first region (S21) and the another portion of the surface of the second passivation structure (140) at the side facing away from the silicon substrate (10) on the second region (S22) is 0.01µm to 0.153µm or 0.048µm to 0.102µm; and/or
the height difference H₂ between the portion of the surface of the second passivation structure (140) at the side facing towards the silicon substrate (10) on the first region (S21) and the another portion of the surface of the second passivation structure (140) at the side facing towards the silicon substrate (10) on the second region (S22) is 0.01µm to 0.153µm or 0.048µm to 0.102µm.

13. The solar cell (100) according to claim 9 or 10, wherein the tunneling layer (12) is any one of a silicon oxide layer and a silicon nitride oxide layer, or any combination thereof; and/or
the tunneling layer (12) has a thickness of 0.5nm to 3nm or 1.5nm to 2.5nm; and/or
the barrier layer (14) is any one of a silicon oxide layer and a silicon carbide layer, or any combination thereof; and/or
the barrier layer (14) has a thickness of 0.5nm to 3nm or 1.5nm to 2nm; and/or,
the second doped layer (131) has a same doping type as that of the silicon substrate (10), and the second doped layer (131) has a surface doping concentration of 1E20cm⁻³ to 9E20cm⁻³ or 3E20cm⁻³ to 5E20cm⁻³; and/or
the third doped layer (132) has a same doping type as that of the silicon substrate (10), and the third doped layer (132) has a surface doping concentration of 2E20cm⁻³ to 3E21cm⁻³ or 5E20cm⁻³ to 2E21cm⁻³; and/or
the second doped layer (131) is a doped polysilicon layer with a thickness of 1nm to 100nm or 1nm to 50nm; and/or
the third doped layer (132) is a doped polysilicon layer with a thickness of 1nm to 150nm or 50nm to 100nm; and/or
a total thickness of the second doped layer (131) and the third doped layer (132) on the first region (S21) is 50nm to 150nm or 60nm to 100nm.

14. The solar cell (100) according to any one of claims 1-13, wherein the first region (S21) comprises a plurality of first sub-regions (101) that are distributed in parallel and equidistantly spaced apart, and the second region (S22) comprises a plurality of second sub-regions (102) that are distributed in parallel and equidistantly spaced apart, the first sub-region (101) and the second sub-region (102) are alternately distributed, and the first sub-region (101) has a width of 20µm to 600µm and the second sub-region (102) has a width of 100µm to 800µm.

15. The solar cell (100) according to any one of claims 1-14, wherein the second passivation structure (140) comprises one of a silicon oxide layer, an alumina layer, a silicon nitride layer and a silicon nitride oxide layer, or any combination of two or more thereof.

16. The solar cell (100) according to claim 15, wherein the second passivation structure (140) comprises a silicon oxide layer, an alumina layer and a silicon nitride layer stacked in sequence, wherein the silicon oxide layer has a thickness of 0.1nm to 3nm, the alumina layer has a thickness of 3nm to 10nm or 4nm to 8nm, and the silicon nitride layer has a thickness of 60nm to 100nm or 70nm to 90nm; or
the second passivation structure (140) comprises a silicon oxide layer (22) and a silicon nitride layer (32) stacked in sequence, wherein the silicon oxide layer (22) has a thickness of 1nm to 30nm, and the silicon nitride layer (32) has a thickness of 60nm to 100nm or 70nm to 90nm.

17. The solar cell (100) according to any one of claims 1-16, wherein the first doped layer (11) has an opposite doping type to that of the silicon substrate (10), and the first doped layer (11) has a surface doping concentration of 1E18cm⁻³ to 5E19cm⁻³, and has a thickness of 10nm to 100nm; and/or
a first passivation structure (130) is disposed on the first doped layer (11), the first passivation structure (130) comprising an alumina layer (21) and a silicon nitride layer (31) stacked in sequence, wherein the alumina layer (21) has a thickness of 3nm to 10nm or 4nm to 8nm, and the silicon nitride layer (31) has a thickness of 60nm to 100nm or 70nm to 90nm.

18. A photovoltaic module comprising the solar cell (100) according to any one of claims 1 to 17.

19. A method for preparing a solar cell, comprising:
providing a silicon substrate, the silicon substrate comprising a first surface and a second surface that are disposed opposite to each other, the second surface comprising a first region and a second region;
preparing a tunneling and passivation contact structure on the first region of the second surface;
preparing a second passivation structure on the first region and the second region of the second surface;
wherein a height difference H₁ between a portion of a surface of the second passivation structure at a side facing away from the silicon substrate on the first region and another portion of the surface of the second passivation structure at the side facing away from the silicon substrate on the second region is 0.01µm to 8µm, and/or a height difference H₂ between a portion of a surface of the second passivation structure at a side facing towards the silicon substrate on the first region and another portion of the surface of the second passivation structure at the side facing towards the silicon substrate on the second region is 0.01µm to 8µm.

20. The method for preparing the solar cell according to claim 19, further comprising:
after said preparing the tunneling and passivation contact structure on the first region of the second surface and before said preparing the second passivation structure on the first region and the second region of the second surface,
preparing a mask layer on the second surface;
performing graphical mask opening on the mask layer on the second region using laser technology;
removing all or a portion of the tunneling and passivation contact structure on the second region using a wet etching process to retain the tunneling and passivation contact structure on the first region; and
removing the mask layer on the first region to expose the tunneling and passivation contact structure on the first region.

21. The method for preparing the solar cell according to claim 20, further comprising:
preparing a texture with a pyramid structure on the first surface and the second surface of the silicon substrate through an alkali texturing process, the pyramid having a size of *0.5µm* to 3µm; and
polishing the second surface of the silicon substrate using an aqueous alkali before preparing the tunneling and passivation contact structure, so as to form a plurality of pyramid bases on the second surface, the pyramid base having a size of 3µm to 20µm or 8µm to *15µm.*

22. The method for preparing the solar cell according to claim 21, wherein the tunneling and passivation contact structure comprises one tunneling layer, one second doped layer, one barrier layer, and a third doped layer stacked in sequence, and the wet etching process comprising:
removing all or a portion of the third doped layer on the second region using alkali etching process; or
removing all of the third doped layer and the barrier layer and at least a part of the second doped layer on the second region using alkali etching process.

23. The method for preparing the solar cell according to claim 21, wherein the tunneling and passivation contact structure comprises one tunneling layer, at least two second doped layers and at least two barrier layers that are alternately stacked, and a third doped layer, the wet etching process comprising:
removing all or a portion of the third doped layer on the second region using alkali etching process; or
removing all of the third doped layer and the barrier layer at the outermost side and at least a portion of the second doped layer at the outermost side on the second region using alkali etching process.
